Europäisches Patentamt

European Patent Office

Office européen des brevets

(11) Publication number: **0 412 502 A1**

# EUROPEAN PATENT APPLICATION

(21) Application number: 90115162.1

(22) Date of filing: 07.08.90

(51) Int. Cl.⁵: **H01L 21/265**, H01L 21/338

(30) Priority: 11.08.89 JP 208507/89

(43) Date of publication of application:
13.02.91 Bulletin 91/07

(84) Designated Contracting States:
DE FR GB

(71) Applicant: KABUSHIKI KAISHA TOSHIBA
72, Horikawa-cho Saiwai-ku
Kawasaki-shi Kanagawa-ken 210(JP)

(72) Inventor: Imamura, Souichi, c/o Intellectual
Property Div.
Kabushiki Kaisha Toshiba, 1-1 Shibaura
1-chome
Minato-ku, Tokyo 105(JP)
Inventor: Suga, Toru, c/o Intellectual Property
Div.
Kabushiki Kaisha Toshiba, 1-1 Shibaura
1-chome
Minato-ku, Tokyo 105(JP)

(74) Representative: Lehn, Werner, Dipl.-Ing. et al
Hoffmann, Eitle & Partner Patentanwälte
Arabellastrasse 4
D-8000 München 81(DE)

(54) Method of making MES type field effect transistor using III-V compound semiconductor.

(57) After a silicon nitride film (21) is deposited on a compound semiconductor substrate (20), another insulating film (22) such as a silicon dioxide film is provided thereon so as to define a channel region (26) in the semiconductor substrate (22). Impurity ions such as Si ions are selectively implanted into the semiconductor substrate (20) in the presence of the silicon nitride film (21) and the insulating film (22), thereby providing drain and source regions (24, 25) and the channel region (26) therein. The insulating film (22) and the silicon nitride film (21) located above the channel region (26) are successively removed to provide a Schottky gate electrode (31) thereon. The silicon nitride film (21) is selectively removed from the substrate surface to provide drain and source electrodes (29, 30) on their regions (24, 25). Accordingly, MES FETs can be produced without exposing the substrate surface during its manufacture.

F I G. 2B

F I G. 2C

# METHOD OF MAKING MES TYPE FIELD EFFECT TRANSISTOR USING III-V COMPOUND SEMICONDUCTOR

The present invention relates to a method of making a MESFET (Metal Semiconductor Field Effect Transistor) using a III-V compound semiconductor.

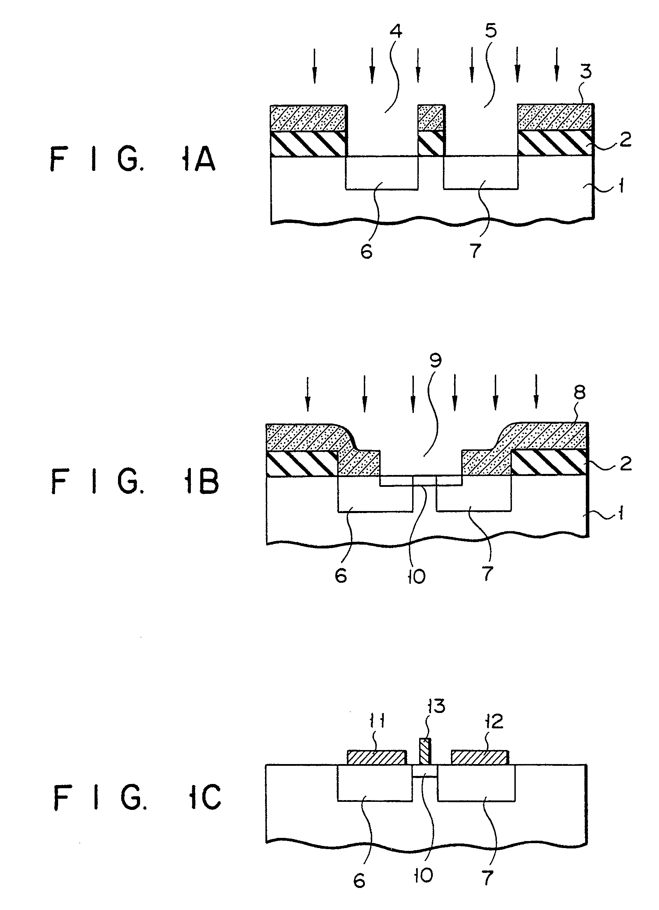

Various types of field effect semiconductor devices using III-V compound semiconductors have been recently proposed. As one of the field effect semiconductor devices, for example, a MESFET with a Schottky gate electrode using a semi-insulating GaAs substrate is made by a process shown in Figs. 1A to 1C. As shown in Fig. 1A, after a silicon oxide layer 2 having a thickness of 5000 Å is formed on a surface of a semi-insulating GaAs substrate 1, openings 4 and 5 for source and drain regions are formed therein, using a resist layer 3 as a mask. Si ions are implanted into the exposed surface of the substrate 1 to provide source and drain regions 6 and 7 therein.

As illustrated in Fig. 1B, the silicon oxide layer 2 located between source and drain regions 6 and 7, which define a channel region, is removed, and the surface of substrate 1 is covered with a resist layer 8. The resist layer 8 is patterned to provide an opening 9 therein. Si ions are implanted again into the exposed surface of substrate 1 through the opening 9 to form a channel region 10 between source and drain regions 6 and 7. The substrate 1 is heat-treated to activate the implanted Si ions. As shown in Fig. 1C, ohmic electrodes 11 and 12 of an Au-Ge alloy are provided on source and drain regions 6 and 7, respectively, and Schottky gate electrode 13 of a Ti-Pt-Au layer is provided on the channel region 10, thereby obtaining a MESFET.

Since, however, the vapor pressure of As is high in III-V compound semiconductors, especially the GaAs substrate, careful consideration has been required for providing FETs such as MESFETs on the substrate. In such a MESFET, it is necessary to lower the impurity concentration of the channel region as compared with that of source and drain regions, and it is required to keep the depth of the channel region at approximately 0.1 $\mu$m. A photolithography process is also required for forming these regions and electrodes. In the photolithography process, unwanted contamination due to resist residue is caused or the substrate surface is damaged by the heat-treatment. Accordingly, desired characteristics of the MESFET cannot be obtained. Furthermore, passivation must be taken into consideration to stabilize the characteristics of the device.

Therefore, it is an object of the present invention to provide a method of making an improved MESFET.

It is another object of the present invention to provide a method of making a MESFET without exposing a surface of a compound semiconductor substrate.

According to an aspect of the present invention, after a silicon nitride layer is deposited on a surface of a compound semiconductor substrate, another insulating layer for defining a channel region is formed thereon. Desired impurity ions are selectively implanted into the substrate in the presence of the silicon nitride layer and the insulating layer to provide source, drain and channel regions therein. Thereafter, the insulating layer and silicon nitride layer located above the channel region are successively removed to provide a Schottky gate electrode, and the silicon nitride layer is selectively removed from the substrate surface to provide source and drain regions.

This invention can be more fully understood from the following detailed description when taken in conjunction with the accompanying drawings, in which:

Figs. 1A to 1C are cross-sectional views showing a conventional process for making a MESFET; and

Figs. 2A to 2D are cross-sectional view showing a process of making a MESFET according to an embodiment of the present invention.

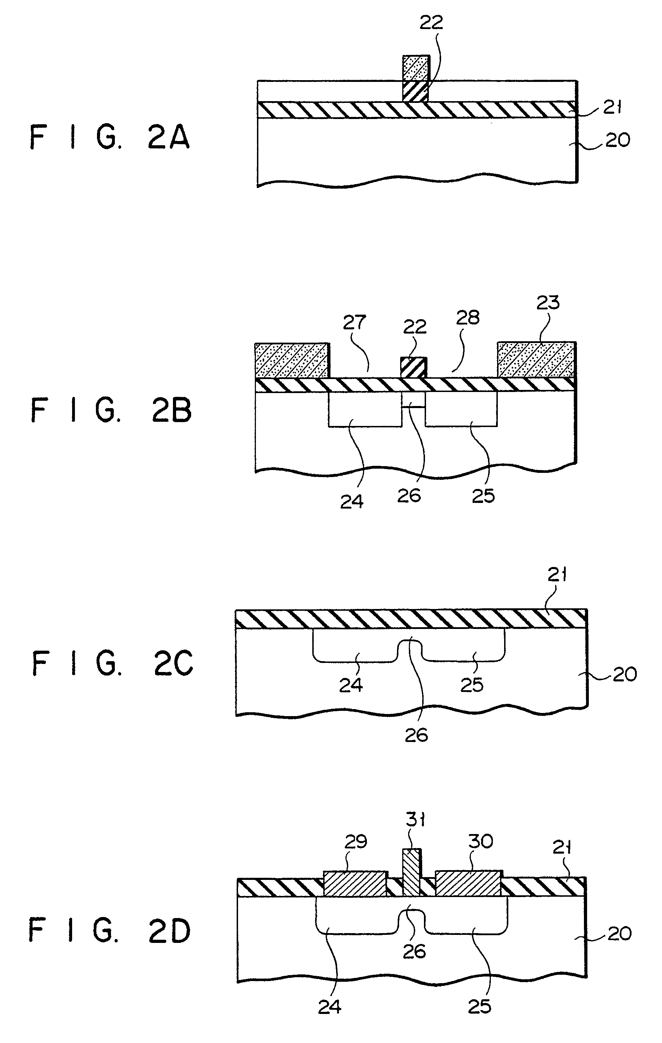

A method of making a MESFET according to an embodiment of the present invention will be described with reference to Figs. 2A to 2D.

A silicon nitride layer 21 is deposited on a surface of a semi-insulating substrate of a III-V compound semiconductor, e.g., GaAs substrate 20 to a thickness of the order of 1500 Å by LPCVD (Low Pressure Chemical Vapor Deposition) techniques, on which a silicon oxide layer 22 having a thickness of about 1000 Å is deposited by CVD techniques. The silicon oxide layer 22 is selectively removed from the substrate surface except an intended channel region by well-known photolithography techniques. The removed portion of layer 22 is enclosed with a dotted line shown in Fig. 2A, and a region overlain the remained silicon oxide layer 22 is the remainder of the resist layer used in the photolithography process. As the photolithography process, both isotropic and anisotropic etchings may be used. More specifically, isotropic etching using ammonium fluoride or anisotropic etching such as reactive ion etching (RIE) utilizing Freon system gases may be applicable to the etching of the silicon layer 22, because the silicon oxide layer 22 is selectively removed without affecting the silicon nitride layer 21.

As is apparent from Fig. 2B, a resist layer 23 with a desired pattern is formed on the silicon nitride layer 21 except the remained silicon oxide layer 22 which covers the intended channel region. In order to render an impurity concentration difference between drain and source regions 24 and 25 and a channel region 26 in a subsequent ion implantation process, the silicon oxide layer 22, located between openings 27 and 28 for forming drain and source regions 24 and 25, and the resist layer 23 are used as ion implantation masks. The width of silicon oxide layer 22 is approximately 2 $\mu$m, and the width of the channel region 26 formed under the silicon oxide layer 22 is 1.6 $\mu$m.

Ion implantation is performed in the presence of both the silicon nitride layer 21 and the silicon oxide layer 22 selectively provided thereon. Si ions are introduced into the GaAs semi-insulating substrate 20 by two ion implantation processes using different acceleration voltages of 250 KeV and 120 KeV to provide N-type drain and source regions 24 and 25 having an impurity concentration of $10^{13}$/cm$^3$. In the ion implantation, since the silicon oxide layer 22 is further provided on the intended channel region, the impurity concentration of the channel region 26 is decreased by one order as compared with that of drain and source regions, and becomes $10^{12}$/cm$^3$. The ion implantation is performed twice for the reason that the impurity concentrations of the respective regions are uniformed in their depth directions. The silicon oxide layer 22 is removed by the isotropic or anisotropic etching technique without damaging the silicon nitride layer 21. In the subsequent annealing process, the activation treatment is carried out in an inert atmosphere (nitrogen or argon) to complete regions 24, 25 and 26. Resist layer 23 is then removed to obtain a structure having a cross section as shown in Fig. 2C. As shown in Fig. 2D, in a final process, drain and source electrodes 29 and 30 and a Schottky gate electrode 31 will be provided. After the silicon nitride layer 21 corresponding to the channel region 26 is selectively removed from the substrate surface by photolithography techniques, Ti, Pt and Au are successively deposited on the exposed surface of the channel region 26 by sputtering or vacuum evaporation techniques to a thickness of about 1000 Å, about 500 Å and about 5000 Å, respectively, thereby providing a Schottky gate electrode 31 thereon.

Similarly, the silicon nitride layer 21 facing drain and source regions 24 and 25 is selectively removed from the substrate surface by the photolithography technique, and then an Au-Ge alloy is deposited on the exposed substrate surface to a thickness of about 0.2 $\mu$m by sputtering or vacuum evaporation techniques, thereby to providing drain and source electrodes 29 and 30 thereon. The Ge content of the alloy is 5 to 10 % by weight.

According to the present invention as described above, since the semi-insulating substrate is treated without exposing the substrate surface, MESFETs with stable characteristics can be easily provided. In addition, since the composition of the semi-insulating substrate having the high vapor pressure is not changed by the silicon nitride layer, MESFETs with a good humidity resisting property can be obtained.

It is further understood by those skilled in the art that the foregoing description is a preferred embodiment of the disclosed method and that various changes and modifications may be made in the invention without departing from the spirit and scope thereof.

## Claims

1. A method of making a MES type field effect transistor comprising selectively implanting impurity ions into a compound semiconductor substrate (20) to provide drain and source regions (24, 25) and a channel region (26) therein, heat-treating said semiconductor substrate (20) to activate said ion-implanted regions (24) to (26), forming a Schottky gate electrode (31) on said channel region (26), and forming an electrode (29, 30) on said drain and source regions (24, 25), respectively, characterized in that after a first insulating film (21) is deposited on a surface of said semiconductor substrate (20), a second insulating film (22) is formed on said first insulating film (21) so as to define said channel region (26) in said semiconductor substrate (20), and that said semiconductor substrate (20) is subjected to a selective ion implantation in the presence of said first and second insulating films (21, 22), thereby providing said drain and source regions (24, 25) and said channel region (26) therein.

2. A method as set forth in claim 1, characterized in that said first insulating film (21) is comprised of a silicon nitride film.

3. A method as set forth in claim 2, characterized in that said second insulating film (22) is comprised of a silicon dioxide film.

4. A method as set forth in claim 1, characterized in that said compound semiconductor substrate (20) is composed of a semi-insulating material of a III - V compound semiconductor.

5. A method as set forth in claim 4, characterized in that said semi-insulating material is composed of GaAs.

6. A method as set forth in claim 1, characterized in that for providing said second insulating (22) film located above said channel region (26) through said first insulating film (21), an insulating film, deposited on said first insulating film (21), is selectively removed by means of lithography techniques except a portion corresponding to said channel region (26).

7. A method as set forth in claim 6, characterized in that said first insulating film (21) is coated with a resist layer (23), and that said resist layer (23) is patterned so as to define intended source and drain regions with both the residual resist layer (23) and said selectively removed second insulating film (22).

8. A method as set forth in claim 1, characterized in that said selective ion implantation in the presence of said first and second insulating films (21, 22) is performed by two ion implantation processes with a different acceleration voltage.

9. A method as set forth in claim 8, characterized in that Si ions are used in said selective ion implantation.

10. A method as set forth in claim 8, characterized in that Si ions are implanted into said semiconductor substrate (20) through said first insulating film (21) to provide said drain and source regions (24, 25) therein.

11. A method as set forth in claim 8, characterized in that Si ions are implanted into said semiconductor substrate (20) through said second and first insulating films (21, 22) to provide said channel region (26) therein.

12. A method as set forth in claim 1, characterized in that said field effect transistor is comprised of MESFET.

13. A method as set forth in claim 1, characterized in that said first insulating film (21) serves as a passivation film.

F I G. 1A

F I G. 1B

F I G. 1C

F I G. 2A

F I G. 2B

F I G. 2C

F I G. 2D

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | US-A-4 782 031 (MATSUSHITA)<br>* Figure 3 *<br>--- | 1,12 | H 01 L 21/265<br>H 01 L 21/338 |
| Y | US-A-4 344 980 (THE USA AS REPRESENTED BY THE SECRETARY OF THE NAVY)<br>* Figure 1 *<br>--- | 1,12 | |
| A | EP-A-0 112 657 (FUJITSU)<br>* Abstract *<br>--- | 1-5,12, 13 | |
| A | US-A-4 505 023 (THE USA AS REPRESENTED BY THE SECRETARY OF THE NAVY)<br>* Page 4, lines 1-55 *<br>--- | 1-4,8,9 ,12 | |
| A | GaAs IC SYMPOSIUM, TECHNICAL DIGEST 1986, Grenelefe, Florida, 28th - 30th October 1986, pages 55-58, IEEE, New York, US; I. OHTA et al.: "An ideal-profile implantation process for GaAs analog MMICs"<br>* Figure 3 *<br>--- | 1,3-5, 12 | |
| A | G.E.C. JOURNAL OF RESEARCH, vol. 1, no. 3, 1983, pages 174-177, Rugby, GB; D.C. BARTLE et al.: "Selective area ion implantation for gallium arsenide microwave devices and circuits"<br>* Figure 4 *<br>--- | 1,4,5, 12 | **TECHNICAL FIELDS SEARCHED (Int. Cl.5)**<br><br>H 01 L |
| A | FR-A-2 358 751 (SIEMENS)<br>* Figures 1-6 *<br>---       -/- | 1,4,5, 12 | |

The present search report has been drawn up for all claims

| Place of search | Date of completion of the search | Examiner |
|---|---|---|
| THE HAGUE | 18-10-1990 | GELEBART J.F.M. |

European Patent Office

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | IEEE ELECTRON DEVICE LETTERS, vol. EDL-2, no. 12, December 1981, pages 309-311, IEEE, New York, US; W.M. DUNCAN et al.: "A single step selective implantation technology for multiply doped layers using proximity annealing" * Figure 1 * | 1,4,5, 12 | |

TECHNICAL FIELDS SEARCHED (Int. Cl.5)

The present search report has been drawn up for all claims

| Place of search | Date of completion of the search | Examiner |
|---|---|---|
| THE HAGUE | 18-10-1990 | GELEBART J.F.M. |

EPO FORM 1503 03.82 (P0401)